# EUROPEAN PATENT APPLICATION

(11) **EP 3 883 131 A1**
(43) Date of publication of application: **22.09.2021**
(21) Application number: 19884797.2
(22) Date of filing: 29.10.2019
(51) Int. Cl.: H03H 9/54

(54) **PACKAGING STRUCTURE, SEMICONDUCTOR DEVICE, AND ELECTRONIC APPARATUS**

(30) Priority: 14.11.2018 CN 201811355758
(71) Applicant: Tianjin University, Tianjin 300072 (CN); Rofs Microsystem (Tianjin) Co., Ltd, Tianjin 300462 (CN)
(72) Inventor: YANG, Qingrui, Tianjin 300072 (CN); PANG, Wei, Tianjin 300072 (CN); SUN, Chen, Tianjin 300072 (CN); ZHANG, Menglun, Tianjin 300072 (CN)
(74) Representative: Bandpay & Greuter
(86) International application number: PCT/CN2019/114003
(87) International publication number: WO 2020/098483

(57) **Abstract**

The present invention relates to a packaging structure for a semiconductor device. The semiconductor device includes a first substrate and a second substrate, which are opposite to each other. The packaging structure includes: a gasket structure, protruding from the second substrate toward the first substrate; and an adhesion layer, arranged on the end face of the gasket structure opposite to the first substrate and/or on the surface of the first substrate opposite to the gasket structure, wherein the shape of the cross section of the gasket structure vertical to the extension direction of the gasket is such that the width of the cross section becomes smaller in the protrusion direction of the gasket structure. The present invention further relates to a semiconductor device having the packaging structure, and equipment having the semiconductor device.

## Description

### Field of the Invention

Embodiments of the present invention relate to the field of semiconductors, in particular to a packaging structure for a semiconductor device, a semiconductor device having the packaging structure, and equipment having the semiconductor device.

### Background of the Invention

Since the 1980s, the development trend of portability, multifunctionality, high performance and low cost of various kinds of electronic equipments has put forward higher requirements on semiconductor devices, and has promoted their development towards the direction of miniaturization, high integration, high reliability and high yield. An acoustic wave resonator is an important type of semiconductor device, and is the core device of filters, oscillators and sensors. It plays an important role in the fields of communication filtering, clock generation, navigation and positioning, biochemical sensing, and so on. With the development of the micro-nano manufacturing technology, surface acoustic wave resonators and bulk acoustic wave resonators have been produced successively. The bulk acoustic wave resonator has quickly emerged in the past ten years due to its advantages of high Q value, low temperature drift and compatibility with IC manufacturing process, and has been widely used in wireless communication. In the bulk acoustic wave resonator, its working frequency is inversely proportional to the thickness of a film. Through a good film preparation process, the thickness of a piezoelectric layer of the resonator can be reduced to several hundred nanometers to several micrometers. Therefore, the resonant frequency can be increased to more than several GHz, the high frequency and miniaturization of acoustic wave devices are realized, and the shortcomings of traditional quartz crystal resonators are compensated. However, at the same time, a bare resonator chip is extremely sensitive to the external environment, for example, dust, water vapor, light and heat radiation, mechanical shock and oxidation in the environment may all cause significant drop in the performance of the resonator. Therefore, it is necessary to construct a certain protection structure to effectively isolate the resonator from the external environment, so as to ensure long-term stable operation of the resonator.

A substrate-level packaging structure is a common packaging structure used for protecting MEMS semiconductor devices. The structure usually includes a functional substrate with a chip and a packaging substrate for protecting the chip. In the packaging process, the functional substrate and the packaging substrate are formed as an entirety through the bonding process, so as to realize the sealing protection of the bare chip.

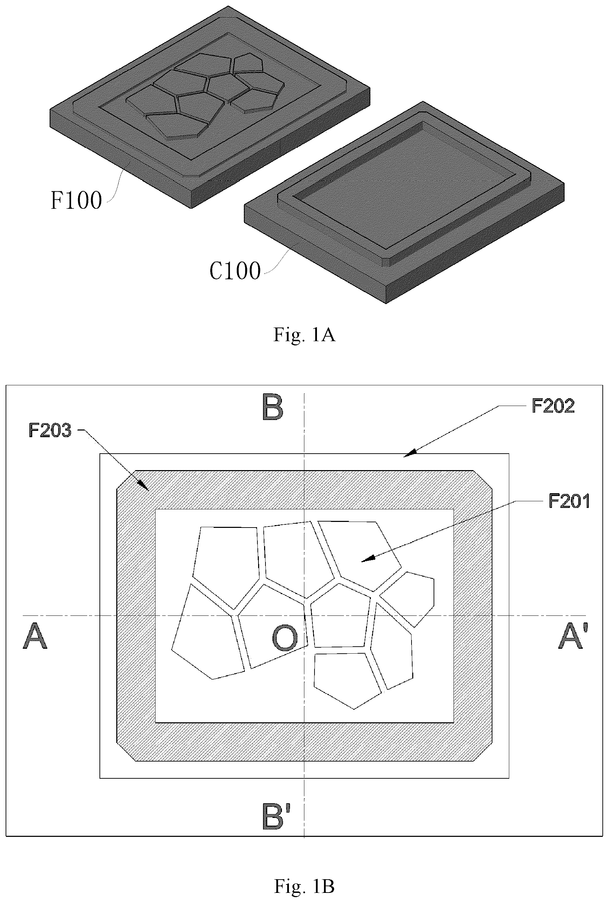

Fig. 1A to Fig. 1D show a traditional packaging structure.

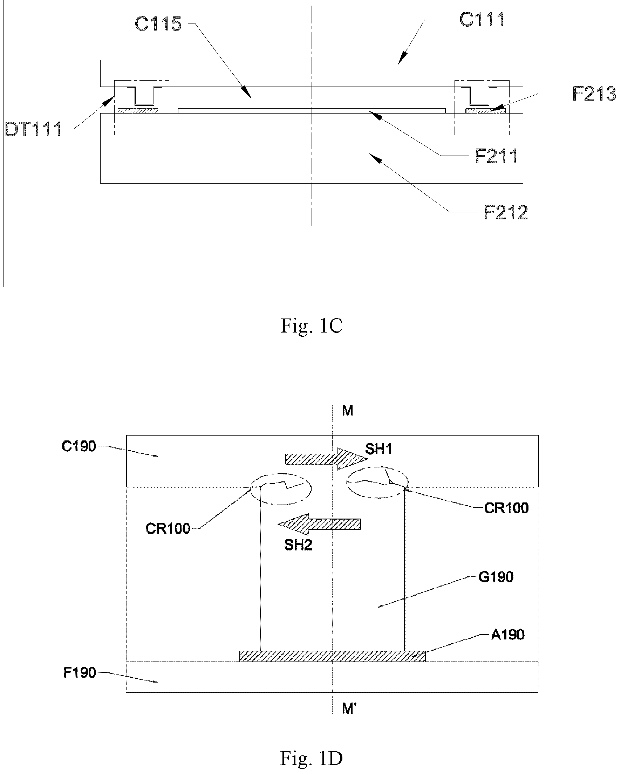

Fig. 1A is a schematic diagram of basic components of the traditional packaging structure. As shown in Fig. 1A, the packaging structure includes a functional substrate F100 and a packaging substrate C100, wherein the top view of F100 is shown in Fig. 1B. The main structure of the functional part shown in Fig. 1B includes an acoustic wave filter core part F201, a bonding layer part F203 (shaded part), and a substrate part F202. The above structure is cut along a straight line AA' to obtain the bonding cross section structure as shown in Fig. 1C (the structure includes the packaging substrate C100).

In the packaging cross section structure shown in Fig. 1C, F212 represents the substrate of the functional part, F211 represents a filter core, F213 represents a bonding layer metal, C111 represents the packaging substrate, and both sides of C111 have protrusion structures (gasket structures), so that a hollow cavity C115 can be formed between the filter core and the packaging substrate during the packaging.

Fig. 1D is an enlarged schematic diagram of the DT111 area in Fig. 1C. In Fig. 1D, C190 represents the packaging substrate, the substrate has a protuberant gasket structure G190, and the cross section of the gasket structure G190 is rectangular; F190 represents a functional substrate, and the upper surface of which extends horizontally to both sides; and the bonding layer metal A190 with a certain thickness between G190 and F190 below the G190 is bonded into an entirety with the functional substrate through the metal layer sealing substrate.

However, the traditional packaging structure shown in Fig. 1D has the problems that: on one hand, the external pressure applied to the system to be packaged during the bonding process is along the MM' direction, but since the response mode of the system to external forces has a tensor relationship, and the geometric shape of the structure to be packaged varies greatly in the lateral direction, it is inevitable to form shearing strain between the packaging substrate C190 and the gasket G190, and a right-angle inflection point structure area (CR100) formed between C190 and G190 is most sensitive to the strain and is prone to cracks or even breakage, thus seriously affecting the packaging reliability. On the other hand, when an external impact force directly acts on the packaged chip, shearing strain is also formed between the packaging substrate C190 and the gasket G190, which may easily lead to packaging failure.

One solution to solve the above problems is to use a wider gasket. However, under the condition of a certain chip size, the wider gasket structure will make the hollow cavity C115 smaller, thereby affecting the layout and the performance of the functional chip.

### Summary of the Invention

In order to alleviate or solve at least one aspect of the deficiencies that still exist in the above-mentioned bonding type packaging structure, the present invention is proposed.

According to one aspect of an embodiment of the present invention, a packaging structure for a semiconductor device is proposed. The semiconductor device includes a first substrate and a second substrate, which are opposite to each other, the packaging structure includes: a gasket structure, protruding from the second substrate toward the first substrate; and an adhesion layer, arranged on the end face of the gasket structure opposite to the first substrate and/or on the surface of the first substrate opposite to the gasket structure, wherein the shape of the cross section of the gasket structure vertical to the extension direction of the gasket is such that the width of the cross section becomes smaller in the protrusion direction of the gasket structure.

Optionally, the shape of the cross section of the gasket structure vertical to the extension direction of the gasket is a trapezoid.

Optionally, the shape of the cross section of the gasket structure vertical to the extension direction of the gasket is a combined shape of two rectangles with different sizes.

Optionally, the shape of the cross section of the gasket structure vertical to the extension direction of the gasket is a combined shape of three rectangles with different sizes.

Optionally, the shape of the cross section of the gasket structure vertical to the extension direction of the gasket is a combined shape of a trapezoid and a rectangle.

Optionally, the shape of the cross section of the gasket structure vertical to the extension direction of the gasket is a combined shape of twotrapezoids with different sizes.

In the cross section of the gasket structure vertical to the extension direction of the gasket, the width of the gasket structure on one side of the second substrate is in the range of 15-140µm, and preferably in the range of 25-70µm; and the width of the gasket structure on one side of the first substrate is in the range of 10-100µm, and preferably in the range of 20-40µm.

For the combination of two geometric bodies, in the cross section of the gasket structure vertical to the extension direction of the gasket, the thickness of the gasket structure on one side of the second substrate is in the range of 1-20µm, and preferably in the range of 2-8µm; and the thickness of the gasket structure on one side of the first substrate is in the range of 1-20µm, and preferably in the range of 2-8µm.

For the combination of three geometric bodies, in the cross section of the gasket structure vertical to the extension direction of the gasket, the thickness of each part of the gasket is in the range of 1-12µm, and preferably in the range of 2-8µm.

Optionally, in the cross section of the gasket structure vertical to the extension direction of the gasket, a line connecting the midpoint of the packaging structure on the first substrate and the midpoint of the packaging structure on the second substrate constitutes a center line; and the shape of the cross section of the gasket structure vertical to the extension direction of the gasket is symmetrical about the center line.

Optionally, the end face of the gasket structure is provided with a pressure enhancement structure. Further, the pressure enhancement structure is a strip-shaped protrusion structure, a netty protrusion structure, or a columnar protrusion structure. Furthermore, the shape of the cross section of the protrusion structure vertical to the extension direction of the gasket is such that the width of the side connected to the end face of the gasket structure is greater than the width of the side away from the end face.

Optionally, in the shape of the cross section of the gasket structure vertical to the extension direction of the gasket, the number of right-angle inflection points is not less than 4; or, in the shape of the cross section of the gasket structure vertical to the extension direction of the gasket, the number of obtuse-angle inflection points is not less than 2.

Optionally, the gasket is made of monocrystalline silicon, quartz, gallium arsenide or sapphire; and the adhesion layer is made of gold, tungsten, molybdenum, platinum, ruthenium, iridium, germanium, copper, titanium, titanium tungsten, aluminum, chromium, arsenic-doped gold, polydimethylsiloxane or polyurethane, or alloys or combinations thereof.

The embodiment of the present invention further proposes a packaging structure for a semiconductor device. The semiconductor device includes a first substrate and a second substrate, which are opposite to each other, the packaging structure includes: a gasket structure, protruding from the second substrate toward the first substrate; and an adhesion layer, arranged on the end face of the gasket structure opposite to the first substrate and/or on the surface of the first substrate opposite to the gasket structure, wherein in the shape of the cross section of the gasket structure vertical to the extension direction of the gasket, the number of right-angle inflection points is not less than 4; or, in the shape of the cross section of the gasket structure vertical to the extension direction of the gasket, the number of obtuse-angle inflection points is not less than 2.

According to another aspect of the embodiment of the present invention, a semiconductor device is proposed, including: the above-mentioned packaging structure; a first substrate; and a second substrate arranged to be opposite to the first substrate, wherein the packaging structure is arranged between the first substrate and the second substrate, and the first substrate, the second substrate and the packaging structure enclose an accommodating space. Optionally, the semiconductor device is a bulk acoustic wave filter.

The embodiment of the present invention further relates to electronic equipment, including the above-mentioned semiconductor device.

### Brief Description of the Drawings

The following descriptions and drawings can better help understand these and other features and advantages in various embodiments disclosed in the present invention. The same reference signs in the drawings always indicate the same components, wherein:
Fig. 1A to Fig. 1D are schematic diagrams of a packaging structure in the prior art;
Fig. 2 is a schematic diagram of a packaging structure according to an exemplary embodiment of the present invention;
Fig. 3 is a schematic diagram of a packaging structure according to another exemplary embodiment of the present invention;
Fig. 4 is a schematic diagram of a packaging structure according to still another exemplary embodiment of the present invention;
Fig. 5 is a schematic diagram of a packaging structure according to still another exemplary embodiment of the present invention;
Fig. 6 is a schematic diagram of a packaging structure according to yet another exemplary embodiment of the present invention;
Fig. 7 is a schematic diagram of a packaging structure according to an exemplary embodiment of the present invention;
Fig. 8 is a schematic diagram of a packaging structure according to an exemplary embodiment of the present invention;
Fig. 9 is a schematic diagram of a packaging structure according to an exemplary embodiment of the present invention;
Fig. 10 is a schematic diagram of a pressure enhancement structure arranged on an end face of a gasket structure according to an exemplary embodiment of the present invention;
Fig. 11 is a schematic diagram of a pressure enhancement structure arranged on an end face of a gasket structure according to an exemplary embodiment of the present invention;
Fig. 12 is a schematic diagram of a pressure enhancement structure arranged on an end face of a gasket structure according to an exemplary embodiment of the present invention.

### Detailed Description of the Embodiments

The technical solutions of the present invention will be further described below in detail through the embodiments and in conjunction with the drawings. In the specification, the same or similar reference signs indicate the same or similar components. The following description of the embodiments of the present invention with reference to the drawings is intended to explain the general inventive concept of the present invention, and should not be construed as a limitation to the present invention.

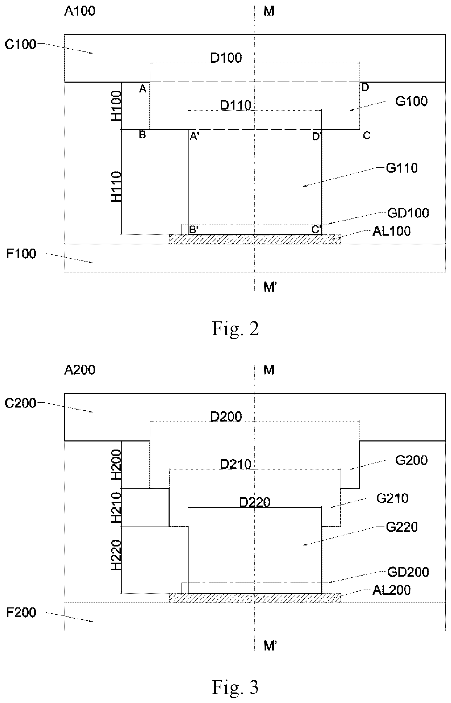

A packaging structure for a semiconductor device according to an embodiment of the present invention is described below with reference to Figs. 2-9.

By improving the geometric structure of a gasket structure, the present invention realizes the reinforcement of the structure at the junction of the gasket and a packaging substrate, and reduces the sensitivity to shearing strain at an inflection point structure and disperses the stress at the same time. The inventor finds that the shearing strain can be shared by increasing the number of right-angle inflection points relative to the prior art, or the shearing strain resistance of the gasket structure can be improved by reducing the right-angle inflection points relative to the prior art.

Based on this, the embodiment of the present invention proposes a packaging structure for a semiconductor device. As shown in Figs. 2-9, the semiconductor device includes a first substrate F100 (F200, F300, F400, F500, F600, F700, F800) and a second substrate C100 (C200, C300, C400, C500, C600, C700, C800), which are opposite to each other, the packaging structure includes: a gasket structure, protruding from the second substrate toward the first substrate; and an adhesion layer AL100 (AL200, AL300, AL400, AL500, AL600, AL700, AL800), arranged on the end face of the gasket structure opposite to the first substrate and/or on the surface of the first substrate opposite to the gasket structure, wherein the shape of the cross section of the gasket structure vertical to the extension direction of the gasket is such that the width of the cross section becomes smaller in the protrusion direction of the gasket structure.

It should be pointed out that although in the drawings, the first substrate is a functional substrate and the second substrate is a packaging substrate, the gasket structure can also be arranged on the functional substrate, which can also improve the shearing strain resistance of the gasket structure, and this is also within the protection scope of the present invention.

Fig. 2 is a schematic diagram of a packaging structure according to an exemplary embodiment of the present invention. Fig. 2 shows a packaging structure C100, a functional substrate F100, a bonding layer AL100 located on the functional substrate F100, and a gasket structure protruding downward from the lower surface of the packaging structure C100.

As shown in Fig. 2, the cross section of the gasket structure in the present embodiment (cut vertical to the extension direction of the gasket) includes a rectangular protrusion G100 (rectangle ABCD in Fig. 2) and a rectangular protrusion G110 (rectangle A'B'C'D' in Fig. 2) from top to bottom, wherein the length D100 (corresponding to the width of the cross section) of the rectangle G100 is in the range of 25-60µm, the width H100 (corresponding to the height of the cross section) is in the range of 2-8µm; the length D110 of the rectangle G110 is in the range of 20-40µm, and the width H110 is in the range of 2-8µm. In the specific implementation, it is ensured that D100 is greater than D110.

In a further embodiment, the rectangle G100 and the rectangle G110 are both symmetrical with respect to the straight line MM', MM' connects the midpoint of AD and the midpoint of B'C', and thus can be used as the center line of the gasket structure.

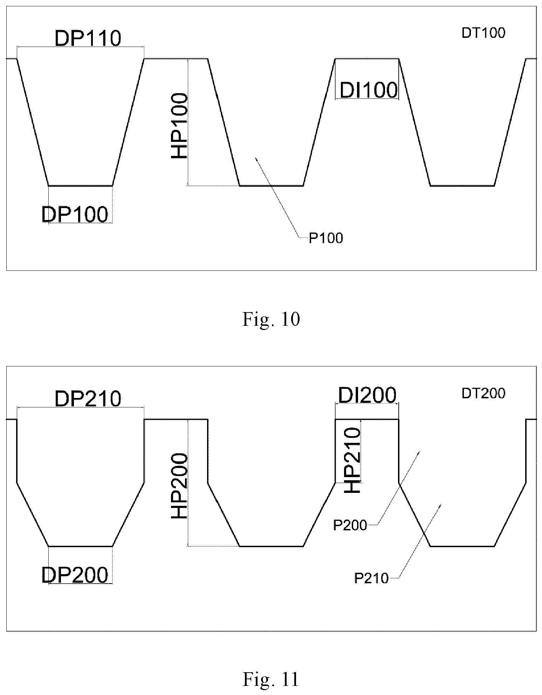

There may be detailed structures in the tail end area GD100 of the protrusion G110, see Figs. 10-12.

In the embodiment of the packaging structure shown in Fig. 2, on one hand, the structure at the junction of the gasket structure and the lower surface of the packaging structure is widened, thereby improving the shearing strain resistance here; and on the other hand, the number of right-angle inflection points between the structures is increased from 2 in the traditional structure to 4, thereby being conducive to dispersing the negative effects caused by shearing strain.

At the same time, since the upper surface of the functional substrate F100 near the right side of the gasket structure in Fig. 2 has a filter core structure, the cross section structure that has a large upper part and a small lower part of the gasket structure in Fig. 2 is also conducive to avoid the filter structure involved above during the packaging, this advantage is inherited in the subsequent embodiments, and thus is not repeatedly described.

In the schematic diagram of the above embodiment, the dotted lines AD and A'D' in Fig. 2 are only used as auxiliary lines to specifically describe the division of geometric areas, and do not exist in a real cross section structure; and in addition, specific descriptions of the geometric areas such as 'rectangle ABCD' are only presented in the present embodiment A100 as schematic illustrations. The division of the geometric areas in the subsequent embodiments is similar to that in the present embodiment, and thus the above detailed description is not used.

Fig. 3 is a schematic diagram of a packaging structure according to an exemplary embodiment of the present invention. Fig. 3 shows a packaging structure C200, a functional substrate F200, a bonding layer AL200 located on the functional substrate F200, and a gasket structure protruding downward from the lower surface of the packaging structure C200.

As shown in Fig. 3, the cross section of the gasket structure in the present embodiment includes a rectangular protrusion G200, a rectangular protrusion G210 and a rectangular protrusion G220 from top to bottom, wherein the length D200 of the rectangle G200 is in the range of 30-60µm, and the height H200 of the rectangle G200 is in the range of 2-5µm; the length D210 of the rectangle G210 is in the range of 25-50µm, the height H210 of the rectangle G210 is in the range of 2-5µm; the length D220 of the rectangle G220 is in the range of 20-40µm, and the height H220 of the rectangle G220 is in the range of 2-5µm; and in the specific implementation, it is ensured that D200 is greater than D210, and D210 is greater than D220.

Optionally, the rectangle G200, the rectangle G210 and the rectangle G220 are all symmetrical about the straight line MM'.

There may be detailed structures in the tail end area GD200 of the protrusion G220, see Figs. 10-12.

This embodiment further strengthens the structure of the key part and disperses the influence of stress with 6 right-angle inflection points, thereby further improving the reliability of the structure.

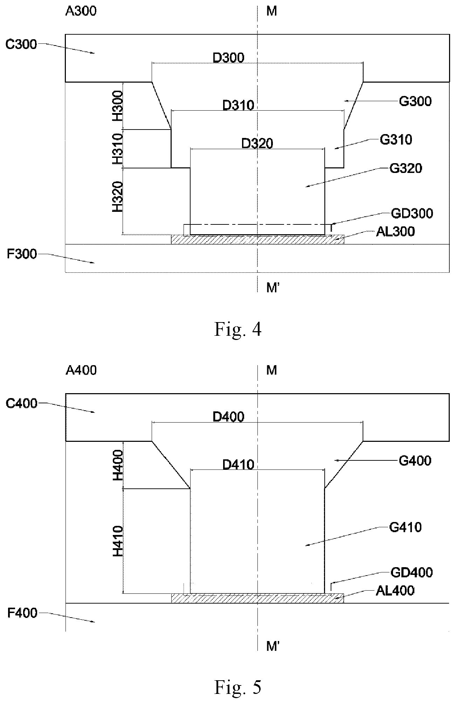

Fig. 4 is a schematic diagram of a packaging structure according to an exemplary embodiment of the present invention. Fig. 4 shows a packaging structure C300, a functional substrate F300, a bonding layer AL300 located on the functional substrate F300, and a gasket structure protruding downward from the lower surface of the packaging structure C300.

As shown in Fig. 4, the cross section of the gasket structure in the present embodiment includes an inverted trapezoidal protrusion G300, a rectangular protrusion G310 and a rectangular protrusion G320 from top to bottom. The length D300 of the upper bottom of the trapezoid G300 is in the range of 30-60µm, the length D310 of the lower bottom of the trapezoid G300 is in the range of 25-50um, and the height H300 of the trapezoid G300 is in the range of 2-5um; the rectangle G310 has the same length as the length D310 of the lower bottom of the trapezoid, and its width H310 is in the range of 2-5µm; the length D320 of the rectangle G320 is in the range of 20-40µm, and the width H320 of the rectangle G320 is in the range of 2-5µm; and in the specific implementation, it is ensured that D300 is greater than D310, and D310 is greater than D320.

Optionally, the trapezoid G300, the rectangle G310 and the rectangle G320 are all symmetrical about the straight line MM'.

There may be detailed structures in the tail end area GD300 of the protrusion G320, see Figs. 10-12.

In the present embodiment, a rectangular structure is replaced with a trapezoidal structure, its advantage is that four obtuse-angle inflection point structures can be formed to replace four of the six right-angle inflection point structures in the A200, in this way, the sensitivity to the shearing strain at the inflection points can be further reduced, and the stability of the structure is further improved as a result.

Fig. 5 is a schematic diagram of a packaging structure according to an exemplary embodiment of the present invention. Fig. 5 shows a packaging substrate C400, a functional substrate F400, a bonding layer AL400 located on the functional substrate F400, and a gasket structure protruding downward from the lower surface of the packaging substrate C400.

As shown in Fig. 5, the cross section of the gasket structure in the present embodiment includes an inverted trapezoidal protrusion G400 and a rectangular protrusion G410 from top to bottom, wherein the length D400 of the upper bottom of the trapezoid G400 is in the range of 25-60µm, the length D410 of the lower bottom of the trapezoid G400 is in the range of 20-40um, and the height H400 of the trapezoid G400 is in the range of 2-8um; the rectangle G410 has the same length as the length D410 of the lower bottom of the trapezoid, and its width H410 is in the range of 2-8µm; and in the specific implementation, it is ensured that D400 is greater than D410.

In an optional embodiment, both the trapezoid G400 and the rectangle G410 are symmetrical about the straight line MM'.

There may be detailed structures in the tail end area GD400 of the protrusion G410, see Figs. 10-12.

In the present embodiment, a combination of a trapezoidal structure and a rectangular structure is adopted, which can further reduce the sensitivity to shearing strain at the inflection points, and can simplify the processing process at the expense of a small part of stability at the same time.

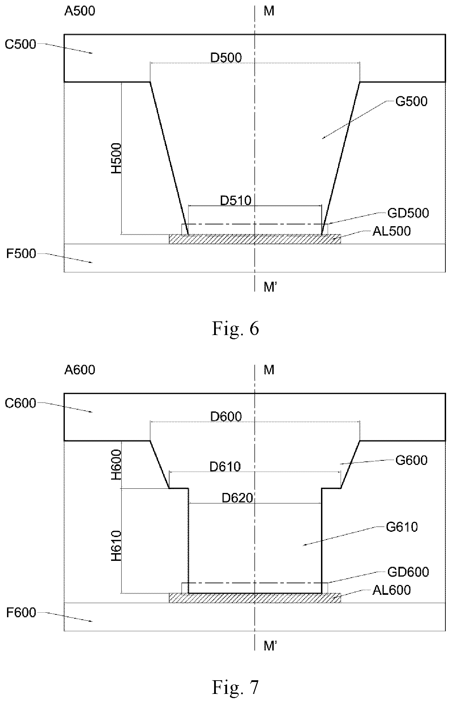

Fig. 6 is a schematic diagram of a packaging structure according to an exemplary embodiment of the present invention. Fig. 6 shows a packaging structure C500, a functional substrate F500, a bonding layer AL500 located on the functional substrate F500, and a gasket structure protruding downward from the lower surface of the packaging structure C500.

As shown in Fig. 6, the cross section of the gasket structure in the present embodiment only includes an inverted trapezoidal protrusion G500. The length D500 of the upper bottom of the trapezoid G500 is in the range of 25-60µm, the length D510 of the lower bottom of the trapezoid G500 is in the range of 20-40um, and the height H500 of the trapezoid G500 is in the range of 4-16um; and in the specific implementation, it is ensured that D500 is greater than D510.

In an optional embodiment, the trapezoid G500 is symmetrical about the straight line MM'.

There may be detailed structures in the tail end area GD500 of the protrusion G500, see Figs. 10-12.

In the present embodiment, the two rectangular structures in the embodiment in Fig. 2 are replaced with one trapezoidal structure, and on the basis of the same widened structure at the junction of the gasket and the packaging substrate, two obtuse-angle inflection point structures are introduced.

At the same time, in the embodiment in Fig. 6, while further reducing the sensitivity to the shearing strain at the inflection points, the processing process can be greatly simplified at the expense of a small part of stability.

Fig. 7 is a schematic diagram of a packaging structure according to an exemplary embodiment of the present invention. Fig. 7 shows a packaging substrate C600, a functional substrate F600, a bonding layer AL600 located on the functional substrate F600, and a gasket structure protruding downward from the lower surface of the packaging substrate C600.

As shown in Fig. 7, the cross section of the gasket structure in the present embodiment includes an inverted trapezoidal protrusion G600 and a rectangular protrusion G610 from top to bottom, wherein the length D600 of the upper bottom of the trapezoid G600 is in the range of 30-60µm, the length D610 of the lower bottom of the trapezoid G600 is in the range of 25-50um, and the height H600 of the trapezoid G600 is in the range of 2-8um; the length D620 of the rectangle G610 is in the range of 25-40µm, and the width H610 of the rectangle G610 is in the range of 2-8µm; and in the specific implementation, it is ensured that D600 is greater than D610, and D610 is greater than D620.

In an optional embodiment, the trapezoid G600 and the rectangle G610 are symmetrical about the straight line MM'.

There may be detailed structures in the tail end area GD600 of the protrusion G610, see Figs. 10-12.

In the present embodiment, one trapezoidal structure and one rectangular structure are adopted, which has two more right-angle inflection point structures than the embodiment in Fig. 6.

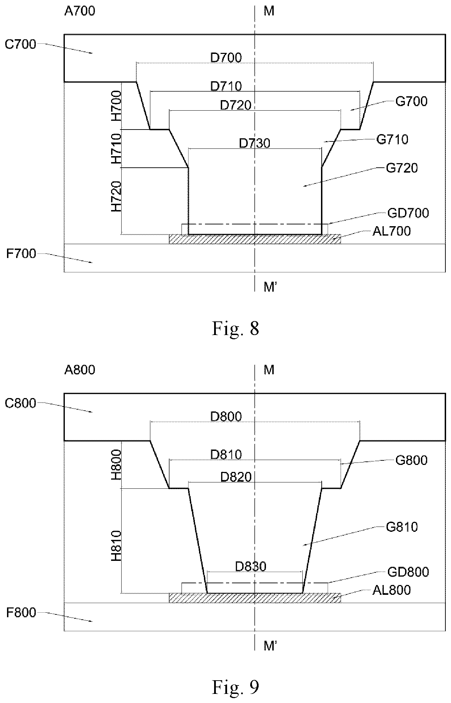

Fig. 8 is a schematic diagram of a packaging structure according to an exemplary embodiment of the present invention. Fig. 8 shows a packaging substrate C700, a functional substrate F700, a bonding layer AL700 located on the functional substrate F700, and a gasket structure protruding downward from the lower surface of the packaging substrate C700.

As shown in Fig. 8, the cross section of the gasket structure in the present embodiment includes an inverted trapezoidal protrusion G700, an inverted trapezoidal protrusion G710 and a rectangular protrusion G720 from top to bottom, wherein the length D700 of the upper bottom of the trapezoid G700 is in the range of 35-70µm, the length D710 of the lower bottom of the trapezoid G700 is in the range of 30-60µm, and the height H700 of the trapezoid G700 is in the range of 2-5um; the length D720 of the upper bottom of the trapezoid G710 is in the range of 25-50µm, the length D730 of the lower bottom of the trapezoid G710 is in the range of 20-40µm, and the width H710 of the trapezoid G710 is in the range of 1-3µm; the length of the rectangle G720 is the same as that of D730, and the width H720 of the rectangle G720 is in the range of 1-5µm; and in the specific implementation, it is ensured that D700 is greater than D710, D710 is greater than D720, and D720 is greater than D730.

In an optional embodiment, the trapezoids G700, G710 and the rectangle G720 are symmetrical about the straight line MM'.

There may be detailed structures in the tail end area GD700 of the protrusion G720, see Figs. 10-12.

In the present embodiment, two trapezoidal structures and one rectangular structure are adopted to form a total of six obtuse-angle inflection point structures, which can greatly improve the shearing strain resistance of the structure.

Fig. 9 is a schematic diagram of a packaging structure according to an exemplary embodiment of the present invention. Fig. 9 shows a packaging substrate C800, a functional substrate F800, a bonding layer AL800 located on the functional substrate F800, and a gasket structure protruding downward from the lower surface of the packaging substrate C800.

As shown in Fig. 9, the cross section of the gasket structure in the present embodiment includes an inverted trapezoidal protrusion G800 and an inverted trapezoidal protrusion G810 from top to bottom. The length D800 of the upper bottom of the trapezoid G800 is in the range of 35-70µm, the length D810 of the lower bottom of the trapezoid G800 is in the range of 30-60µm, and the height H800 of the trapezoid G800 is in the range of 2-8µm; the length D720 of the upper bottom of the trapezoid G810 is in the range of 25-50µm, the length D730 of the lower bottom of the trapezoid G810 is in the range of 20-40µm, and the height H7610 of the trapezoid G810 is in the range of 2-8µm; and in the specific implementation, it is ensured that D800 is greater than D810, D810 is greater than D820, and D820 is greater than D830.

In an optional embodiment, the trapezoid G800 and the trapezoid G810 are symmetrical about the straight line MM'.

It should be particularly noted that in the above-mentioned embodiments, the cross sections of the gasket structure vertical to the extension direction of the gasket are all bilaterally symmetrical about the center line, but the embodiments of the present invention are not limited to the bilaterally symmetrical structure. In the cross section, the gasket structure can also be asymmetrical.

There may be detailed structures in the tail end area GD800 of the protrusion G810, see Figs. 10-12.

In the present embodiment, two trapezoidal structures are adopted to form a total of four obtuse-angle inflection point structures. Compared with the embodiment in Fig. 8, no excessive stability is lost, and the process can be simplified to a certain extent.

In the present invention, the material of the functional substrate, the packaging substrate and the gasket are selected from, but not limited to: monocrystalline silicon (preferred), sapphire, gallium arsenide, quartz, etc.

In the present invention, the material of the bonding layer serving as the adhesion layer is selected from, but not limited to:
gold (preferred), tungsten, molybdenum, platinum, ruthenium, iridium, germanium, copper, titanium, titanium tungsten, aluminum, chromium, arsenic-doped gold, polydimethylsiloxane or polyurethane, or alloys or combinations thereof.

Hereinafter, an embodiment of a periodically distributed pressure enhancement structure arranged on the tail end or the end face of the gasket structure will be described with reference to Figs. 10-12.

As shown in Fig. 10, in the present embodiment, the cross section of the pressure enhancement structure is composed of an inverted isosceles trapezoid P100; the length DP110 of the upper bottom of the trapezoid P100 is in the range of 2-5µm, the length DP100 of the lower bottom of the trapezoid P100 is in the range of 1-3.5µm, and the height HP100 of the trapezoid P100 is in the range of 1-3µm; and the distance between the upper bottoms of two adjacent trapezoids is 1-3.5µm.

As shown in Fig. 11, in the present embodiment, the cross section of the pressure enhancement structure is composed of a rectangle P200 and an inverted isosceles trapezoid P210 from top to bottom; the length DP210 of the rectangle is in the range of 2-5µm, and the width HP210 is in the range of 0.5-1.5µm; the length of the upper bottom of the trapezoid is equal to DP210, and the length DP200 of the lower bottom is in the range of 1-3.5µm; the overall height HP200 of the protrusion is in the range of 1-3µm; and the distance between the lengths of two adjacent rectangles is 1-3.5µm.

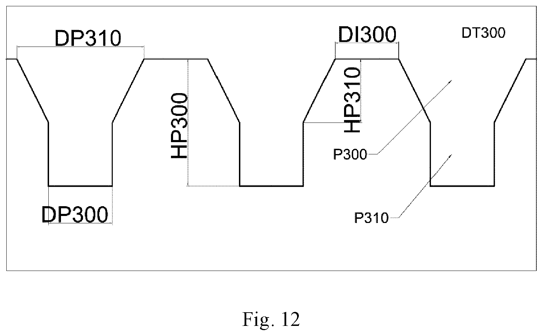

As shown in Fig. 12, in the present embodiment, the cross section of the pressure enhancement structure is composed of an inverted isosceles trapezoid P300 and a rectangle P310 from top to bottom; the length DP310 of the upper bottom of the trapezoid P300 is in the range of 2-5µm, the length DP300 of the lower bottom of the trapezoid P300 is in the range of 1-3.5µm, the height HP310 of the trapezoid P300is in the range of 0.5-1.5µm; the length of the rectangle P310 is equal to DP300; the overall height HP300 of the protrusion is in the range of 1-3µm; and the distance between the lengths of two adjacent rectangles is 1-3.5µm.

If the avoidance of internal core components and the stability of the packaging structure are considered, the size range of the gasket structure can be limited.

In the cross section of the gasket structure vertical to the extension direction of the gasket, the width of the gasket structure on one side of the second substrate is in the range of 15-140µm, and preferably in the range of 25-70µm; and the width of the gasket structure on one side of the first substrate is in the range of 10-100µm, and preferably in the range of 20-40µm.

For the combination of two geometric bodies, in the cross section of the gasket structure vertical to the extension direction of the gasket, the thickness range (that is, the height range) of the gasket structure on one side of the second substrate side is 1-20µm, and preferably 2-8µm; and the thickness of the gasket structure on the side of the first substrate is in the range of 1-20µm, and preferably in the range of 2-8µm.

For the combination of three geometric bodies, in the cross section of the gasket structure vertical to the extending direction of the gasket, the thickness of each part of the gasket is in the range of 1-12µm, and preferably in the range of 2-8µm.

The packaging structure of the present invention can be applied to the packaging of semiconductor devices, for example, can be applied to the packaging of radio frequency filters, and can also be used in other MEMS component packaging structures. Although not shown, the embodiment of the present invention further relates to a semiconductor device, including the above-mentioned packaging structure; a first substrate; and a second substrate, arranged to be opposite to the first substrate, wherein the packaging structure is arranged between the first substrate and the second substrate, and the first substrate, the second substrate and the packaging structure enclose an accommodating space. Optionally, the semiconductor device is a bulk acoustic wave filter.

Although not shown, the embodiment of the present invention further relates to electronic equipment, including the above-mentioned semiconductor device.

Although the embodiments of the present invention have been shown and described, those of ordinary skill in the art can understood that these embodiments can be changed without departing from the principle and spirit of the present invention, and the scope of the present invention is defined by the appended claims and their equivalents.

## Claims

1. A packaging structure for a semiconductor device, the semiconductor device comprises a first substrate and a second substrate, which are opposite to each other, the packaging structure comprises:
a gasket structure, protruding from the second substrate toward the first substrate; and
an adhesion layer, arranged on the end face of the gasket structure opposite to the first substrate and/or on the surface of the first substrate opposite to the gasket structure, wherein:
the shape of the cross section of the gasket structure vertical to the extension direction of the gasket is such that the width of the cross section becomes smaller in the protrusion direction of the gasket structure.

2. The packaging structure according to claim 1, wherein:
the shape of the cross section of the gasket structure vertical to the extension direction of the gasket is a trapezoid.

3. The packaging structure according to claim 1, wherein:
the shape of the cross section of the gasket structure vertical to the extension direction of the gasket is a combined shape of two rectangles with different sizes.

4. The packaging structure according to claim 1, wherein:
the shape of the cross section of the gasket structure vertical to the extension direction of the gasket is a combined shape of three rectangles with different sizes.

5. The packaging structure according to claim 1, wherein:
the shape of the cross section of the gasket structure vertical to the extension direction of the gasket is a combined shape of a trapezoid and a rectangle.

6. The packaging structure according to claim 1, wherein:
the shape of the cross section of the gasket structure vertical to the extension direction of the gasket is a combined shape of two trapezoids with different sizes.

7. The packaging structure according to any one of claims 1-6, wherein:
in the cross section of the gasket structure vertical to the extension direction of the gasket,
in the cross section of the gasket structure vertical to the extension direction of the gasket, the width of the gasket structure on one side of the second substrate is in the range of 15-140µm; and the width of the gasket structure on one side of the first substrate is in the range of 10-100µm.

8. The packaging structure according to claim 7, wherein:
in the cross section of the gasket structure vertical to the extension direction of the gasket, the width of the gasket structure on one side of the second substrate is in the range of 25-70µm.

9. The packaging structure according to claim 7, wherein:
in the cross section of the gasket structure vertical to the extension direction of the gasket, the width of the gasket structure on one side of the first substrate is in the range of 20-40µm.

10. The packaging structure according to claim 7, wherein:
the shape of the cross section of the gasket structure vertical to the extension direction of the gasket is a combined shape of two large and small rectangles; and
in the cross section of the gasket structure vertical to the extension direction of the gasket, the thickness of the gasket structure on one side of the second substrate is in the range of 1-20µm; and the thickness of the gasket structure on one side of the first substrate is in the range of 1-20µm.

11. The packaging structure according to claim 10, wherein:
in the cross section of the gasket structure vertical to the extension direction of the gasket, the thickness of the gasket structure on one side of the second substrate and/or the first substrate is in the range of 2-8µm.

12. The packaging structure according to claim 7, wherein:
the shape of the cross section of the gasket structure vertical to the extension direction of the gasket is a combined shape of three layers of geometric bodies; and
in the cross section of the gasket structure vertical to the extension direction of the gasket, the thickness of each layer of geometric body is in the range of 1-12µm,

13. The packaging structure according to claim 12, wherein:
in the cross section of the gasket structure vertical to the extension direction of the gasket, the thickness of each layer of geometric body is in the range of 2-8µm.

14. The packaging structure according to any one of claims 1-13, wherein:
in the cross section of the gasket structure vertical to the extension direction of the gasket, a line connecting the midpoint of the packaging structure on the first substrate and the midpoint of the packaging structure on the second substrate constitutes a center line; and
the shape of the cross section of the gasket structure vertical to the extension direction of the gasket is symmetrical about the center line.

15. The packaging structure according to any one of claims 1-14, wherein:
the end face of the gasket structure is provided with a pressure enhancement structure.

16. The packaging structure according to claim 15, wherein:
the pressure enhancement structure is a strip-shaped protrusion structure, or a netty protrusion structure, or a columnar protrusion structure.

17. The packaging structure according to claim 16, wherein:
the shape of the cross section of the protrusion structure vertical to the extension direction of the gasket is such that the width of the side connected to the end face of the gasket structure is greater than the width of the side away from the end face.

18. The packaging structure according to claim 1, wherein:
in the shape of the cross section of the gasket structure vertical to the extension direction of the gasket, the number of right-angle inflection points is not less than 4; or
in the shape of the cross section of the gasket structure vertical to the extension direction of the gasket, the number of obtuse-angle inflection points is not less than 2.

19. The packaging structure according to claim 1, wherein:
the gasket is made of monocrystalline silicon, quartz, gallium arsenide or sapphire; and
the adhesion layer is made of gold, tungsten, molybdenum, platinum, ruthenium, iridium, germanium, copper, titanium, titanium tungsten, aluminum, chromium, arsenic-doped gold, polydimethylsiloxane or polyurethane, or alloys or combinations thereof.

20. A packaging structure for a semiconductor device, the semiconductor device comprises a first substrate and a second substrate, which are opposite to each other, the packaging structure comprises:
a gasket structure, protruding from the second substrate toward the first substrate; and
an adhesion layer, arranged on the end face of the gasket structure opposite to the first substrate and/or on the surface of the first substrate opposite to the gasket structure,
wherein:
in the shape of the cross section of the gasket structure vertical to the extension direction of the gasket, the number of right-angle inflection points is not less than 4; or
in the shape of the cross section of the gasket structure vertical to the extension direction of the gasket, the number of obtuse-angle inflection points is not less than 2.

21. A semiconductor device, comprising:
the packaging structure according to any one of claims 1-20;
a first substrate; and
a second substrate arranged to be opposite to the first substrate,
wherein:
the packaging structure is arranged between the first substrate and the second substrate, and the first substrate, the second substrate and the packaging structure enclose an accommodating space.

22. The semiconductor device according to claim 21, wherein:
the semiconductor device is a bulk acoustic wave filter.

23. Electronic equipment, comprising the semiconductor device according to claim 21 or 22.
